(19) Europäisches Patentamt
European Patent Office
Office européen des brevets

(11) Veröffentlichungsnummer: **0 059 988**
**B1**

(12) # EUROPÄISCHE PATENTSCHRIFT

(45) Veröffentlichungstag der Patentschrift: **11.07.84**

(51) Int. Cl.³: **C 08 F 2/50**, C 08 F 283/00, G 03 C 1/68, G 03 F 7/10

(21) Anmeldenummer: **82102315.7**

(22) Anmeldetag: **09.07.79**

(60) Veröffentlichungsnummer der früheren Anmeldung nach Art. 76 EPÜ:

(54) **Photopolymerisierbare Aufzeichnungsmasse, insbesondere zur Herstellung von Druckplatten und Reliefformen.**

(30) Priorität: **14.03.79 DE 2909992**

(43) Veröffentlichungstag der Anmeldung: **15.09.82 Patentblatt 82/37**

(45) Bekanntmachung des Hinweises auf die Patenterteilung: **11.07.84 Patentblatt 84/28**

(84) Benannte Vertragsstaaten: **BE CH DE FR GB IT NL SE**

(56) Entgegenhaltungen:
**DE - A - 2 556 830**
**US - A - 3 668 093**

(73) Patentinhaber: **BASF Aktiengesellschaft, Carl-Bosch-Strasse 38, D-6700 Ludwigshafen (DE)**

(72) Erfinder: **Lechtken, Peter, Dr., Ludwigshafener Strasse 6B, D-6710 Frankenthal (DE)**
Erfinder: **Bronstert, Bernd, Dr., Sonnenstrasse 12B, D-6710 Frankenthal (DE)**
Erfinder: **Hoffmann, Gerhard, Dr., Pappelstrasse 22, D-6701 Otterstadt (DE)**
Erfinder: **Vyvial, Rudolf, Alwin-Mittasch-Platz 11, D-6700 Ludwigshafen (DE)**
Erfinder: **Lynch, John, Dr., Bachusstrasse 15, 6521 Monsheim (DE)**

**EP 0 059 988 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft verbesserte photopolymerisierbare Aufzeichnungsmassen, die überwiegend aus einer Photoinitiator enthaltenden Mischung von a) mindestens einer niedermolkularen Verbindung mit mindestens einer photopolymerisierbaren olefinisch ungesättigten Doppelbindung und b) mindestens einem organischen polymeren Bindemittel bestehen, die eine Acylphosphinoxid-Verbindung als Photoinitiator enthalten.

Photopolymerisierbare Aufzeichnungsmassen, wie sie für die Herstellung von Druckplatten und Reliefformen verwendet werden, sind vielfach beschrieben worden und umfassen sowohl flüssige als auch feste Massen. Beispielsweise sind derartige Aufzeichnungsmassen in der DE-OS 20 40 390 oder FR-PS 15 20 856 beschrieben. Als Photoinitiatoren für die Aufzeichnungsmassen werden hauptsächlich aromatische Ketone wie Benzilketale, Benzoinäther oder $\alpha$-Methylol-Derivate von Benzoinäthern verwendet. Obgleich diese Initiatorsysteme zu brauchbaren Ergebnissen führen, verlangen die modernen Methoden der Aufzeichnungstechnik, insbesondere im Zeitungsdruck immer kürzere Belichtungszeiten, die unter Verwendung der herkömmlichen Photoinitiatorsysteme nicht befriedigend erfüllt werden können. So sind die umweltfreundlichen, wasserauswaschbaren Druckplatten bislang noch so reaktionsträge, dass durch den Kunstgriff der Vorbelichtung für eine ausreichende Sensibilisierung gesorgt werden muss. Neben anderen Nachteilen bedeutet dies jedoch einen zusätzlichen Arbeitsgang.

Bei den Aufzeichnungsmassen mit den herkömmlichen Initiatorsystemen wird häufig auch die Reliefstruktur ungünstig ausgebildet und muss durch besondere Massnahmen, wie Zusätze photochromer Verbindungen, Steuerung der Lichtreflexion am Trägerblech oder durch Zusatz besonderer Inhibitoren, die aber die Belichtungszeit verlängern, verbessert werden.

Der vorliegenden Erfindung lag die Aufgabe zugrunde, durch schnellere, reaktivere Initiatoren die Lichtempfindlichkeit von Aufzeichnungsmassen bei möglichst gleichzeitiger Reliefverbesserung zu erhöhen.

Es wurde nun überraschend gefunden, dass bestimmte Acylphosphinoxid-Verbindungen eine wesentlich schnellere Aushärtung photopolymerer Aufzeichnungssysteme erlauben als dies mit den herkömmlichen bekannten Photoinitiatoren möglich ist, und sie in der Lage sind, die Reliefstruktur photopolymerer Reliefformen zu verbessern.

Gegenstand der Erfindung sind somit photopolymerisierbare Aufzeichnungsmassen, insbesondere für die Herstellung von Druckplatten und Reliefformen überwiegend bestehend aus einer Photoinitiator enthaltenden Mischung a) mindestens einer niedermolekularen Verbindung mit mindestens einer photopolymerisierbaren olefinisch ungesättigten Doppelbindung und b) mindestens einem organischen polymeren Bindemittel, die als Photoinitiator Acylphosphinoxid-Verbindungen der Formel

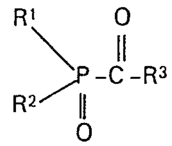

(I)

enthalten, wobei

$R^1$ für einen Alkylrest mit 1 bis 6 Kohlenstoffatomen, einen Cycloalkylrest mit 5 oder 6 Ringkohlenstoffatomen, einen gegebenenfalls halogen-, alkyl- oder alkoxy-substituierten Arylrest oder einen S- oder N-haltigen fünf- oder sechsgliedrigen heterocyclischen Rest steht;

$R^2$ die Bedeutung von $R^1$ hat, wobei $R^1$ und $R^2$ gleich oder verschieden sein können, oder für einen Alkoxy-, Aryloxy- oder einen Arylalkoxyrest steht, oder $R^1$ und $R^2$ miteinander zu einem Ring verbunden sind;

$R^3$ einen tertiären Alkylrest mit 4 bis 18 C-Atomen oder tertiären Cycloalkylrest mit 5 oder 6 Ringkohlenstoffatomen darstellt, oder einen Cycloalkylrest, Arylrest, oder 5- oder 6gliedrigen heterocyclischen Rest darstellt, der mindestens in den beiden ortho-Stellungen zur Carbonylgruppierung Substituenten A und B gebunden enthält, wobei A und B Alkyl-, Alkoxy-, Alkoxyalkyl-, Alkylthio-, Cycloalkyl- oder Arylreste oder Halogenatome sind und A und B gleich oder verschieden sein können.

Das Merkmal «in den beiden ortho-Stellungen zur Carbonylgruppierung die Substituenten A und B gebunden enthält», ist hier so zu verstehen, dass die Substituenten A und B an den beiden zur Verknüpfungsstelle mit der Carbonylgruppe benachbarten Ringkohlenstoffatomen, die substituiert sein können, gebunden sind. Dies bedeutet, dass der $\alpha$-Naphthylrest mindestens in den 2,8-Stellungen und der $\beta$-Naphthylrest mindestens in der 1,3-Stellungen die Substituenten A und B gebunden enthält. Beim Cyclohexylrest sind die Substituenten A und B in den 2,6-Stellungen, beim Cyclopentylrest in den 2,5-Stellungen.

Als Acylphosphinoxid-Verbindungen sind beispielsweise zu nennen: Acylphosphinoxide und Acylphosphinsäureester. Bezüglich der Formel (I) ist im einzelnen folgendes auszuführen:

$R^1$ kann sein ein geradkettiger oder verzweigter Alkylrest mit 1 bis 6 C-Atomen, wie Methyl, Äthyl, 1-Propyl, n-Propyl, n-Butyl, Amyl oder n-Hexyl, ein Cyclopentyl- oder Cyclohexylrest, ein Arylrest, wie Phenyl oder Naphthyl, ein halogensubstituierter Arylrest wie Mono- oder Dichlorphenyl, ein alkylsubstituierter Arylrest, wie Methylphenyl, Äthylphenyl, Isopropylphenyl, tert.-Butylphenyl oder Dimethylphenyl, ein alkoxysubstituierter Arylrest, wie Methoxyphenyl, Äthoxyphenyl, Dimethoxyphenyl, ein S- oder N-haltiger fünf- oder sechsgliedriger heterocyclischer Rest, wie Thiophenyl oder Pyridyl.

$R^2$ kann die Bedeutung von $R^1$ haben und ferner sein ein Alkoxylrest mit insbesondere 1 bis 6 C-Atomen, wie Methoxyl, Äthoxyl, i-Propoxyl, Butoxyl oder Äthoxyäthoxyl, ein Aryloxyrest, wie Phenoxy oder Methylphenoxy, oder ein Arylalkoxyrest wie Benzyloxy.

$R^1$ kann mit $R^2$ auch zu einem Ring verbunden sein, wie z.B. in Acyl-phosphonsäure-o-phenylen-estern.

$R^3$ kann z.B. sein ein Cycloalkyl-, Phenyl- oder Naphthylrest, ein fünf- oder sechsgliedriger heterocyclischer Rest mit insbesondere S-, N- oder O-Ringatomen im Heterocyclus, z.B. ein Furyl-, Pyrrolyl-, Thienyl-, Pyranyl- oder Pyridylrest, der zumindest in den beiden ortho-Stellungen zur Carbonylgruppe die Substituenten A und B gebunden enthält. Geeignete Substituenten A und B sind gegebenenfalls verzweigte Alkylreste mit insbesondere 1 bis 6, vorzugsweise 1 bis 4 Kohlenstoffatomen, wie Methyl, Äthyl, Propyl, iso-Propyl, Butyl, iso-Butyl und tert.-Butyl; gegebenenfalls substituierte Cycloalkylreste, wie Cyclohexyl, gegebenenfalls substituierte Arylreste, z.B. Phenyl oder Toluyl, Alkoxy- oder Alkylthioreste mit insbesondere 1 bis 6, vorzugsweise 1 bis 4 Kohlenstoffatomen, wie Methoxy, Äthoxy, Propoxy, iso-Propoxy, n-Butoxy, Methylthio, Äthylthio, Propylthio, iso-Propylthio, n-Butylthio, sec.-Butylthio und tert.-Butylthio; Alkoxyalkylreste mit insbesondere 2 bis 12, vorzugsweise 2 bis 8 Kohlenstoffatomen wie 2-Methoxyäthyl oder tert.-Butoxy-2-propyl; Halogenatome, wie insbesondere ein Chlor- oder Bromatom.

Die $R^3$ gebunden enthaltenden Acylphosphinoxid-Verbindungen können beispielsweise durch die Strukturformel II bis VII veranschaulicht werden,

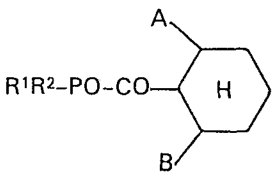
(II)

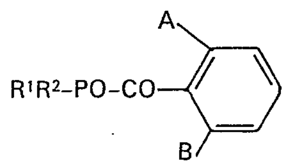
(III)

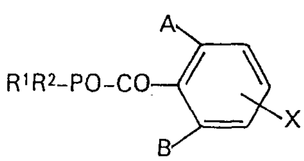
(IV)

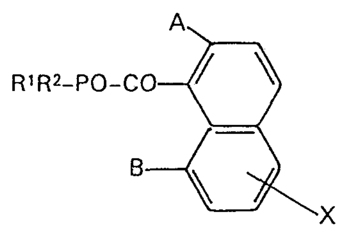
(V)

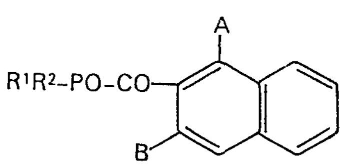
(VI)

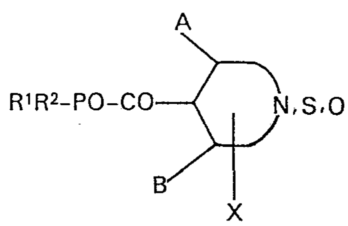
(VII)

wobei X für gegebenenfalls weitere Substituenten in den Cycloalkyl-, Phenyl-, Naphthyl- oder heteroxyclischen Resten steht, die die Bedeutung von A oder B haben.

$R^3$ kann aber auch ein tertiärer Alkyl- oder Cycloalkylrest (mit jeweils einem tertiären C-Atom in Nachbarstellung zur Carbonylgruppe) sein, wie tert. Butyl, 1,1-Dimethylheptyl, 1-Methylcyclohexyl oder 1-Methylcyclopentyl.

Die Herstellung von Phosphinoxid-Verbindungen kann durch Umsetzung von Säurehalogeniden der Formel

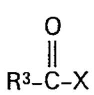
X = C1, Br,

mit Phosphinen der Formel

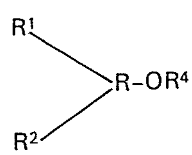
$R^4$ = geradkettiger oder verzweigter $C_1$- bis $C_6$-Alkyl, oder Cycloalkyl mit 5 oder 6 C-Atomen

erfolgen. Die Umsetzung kann in einem Lösungsmittel, wie einem Kohlenwasserstoff oder Kohlenwasserstoffgemisch, wie Petroläther, Toluol, Cyclohexan, einem Äther, anderen üblichen inerten organischen Lösungsmitteln, oder auch ohne Lösungsmittel bei Temperaturen zwischen -30°C und +110°C, bevorzugt bei 10 bis 70°C, ausgeführt werden. Das Produkt kann aus dem Lösungsmittel direkt auskristallisiert werden, hinterbleibt nach dem Abdampfen oder wird im Vakuum destilliert. Die Gewinnung der Säurehalogenide

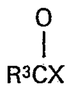

und des substituierten Phosphins $R^1R^2POR^4$ erfolgt nach Verfahren, die dem Fachmann aus der Literatur bekannt sind (z.B. K. Sasse in Houben-Weyl, Bd. 12/1, S. 208–209, G. Thieme-Verlag, Stuttgart).

Die Herstellung erfindungsgemäss verwendeter Phosphinoxid-Verbindungen lässt sich folgendermassen beispielhaft beschreiben:

2,4,6-Trimethylbenzoyl-phenylphosphinsäuremethylester:

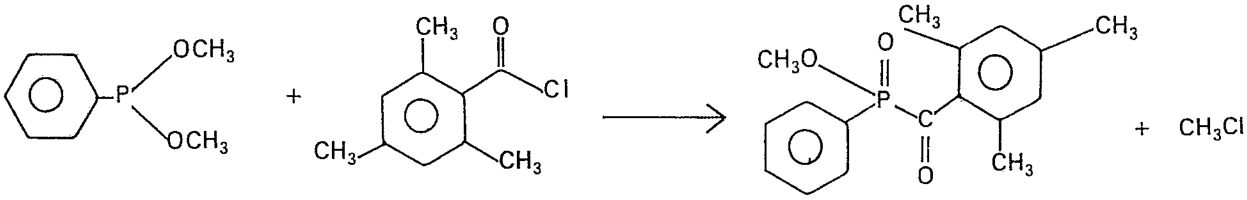

2,3,5,6-Tetramethyl-benzoyl-diphenylphosphinoxid:

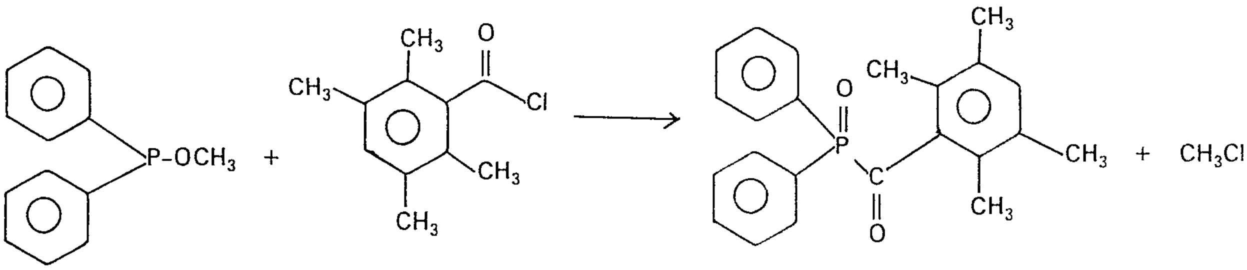

Sehr geeignet sind Aufzeichnungsmassen, die Phosphinoxid-Verbindungen der Formel I enthalten, wobei $R^1$ = Aryl mit 6 bis 12 C-Atomen wie Naphthyl, Toluyl und insbesondere Phenyl und $R^2$ = $C_1$–$C_4$-Alkoxy wie Methoxy oder Äthoxy und insbesondere Aryl mit 6 bis 12 C-Atomen, vorzugsweise Phenyl darstellt. Überraschend hochwirksam bei gleichzeitiger hoher Stabilität sind photopolymerisierbare Aufzeichnungsmassen mit Acylphosphinoxid-Verbindungen der Formel I, deren Acylrest $-CO-R^3$ sich von einer tertiären aliphatischen oder cycloaliphatischen Carbonsäure oder von einer mindestens in 2,6-Stellung (mit A und B) substituierten Benzoesäure ableitet. Sehr geeignete Acylreste dieser Art sind die 2,2-Dimethyl-$C_4$–$C_9$-alkanoyl-, die 2-Methyl-2-äthyl-$C_4$–$C_9$-alkanoyl-Reste sowie die Benzoylreste, die in 2,6-, 2,3,6-, 2,4,6- oder 2,3,5,6-Stellung Substituenten A und B, insbesondere $C_1$–$C_4$-Alkylreste, $C_1$–$C_4$-Alkoxyreste oder Halogenatome aufweisen.

Als Beispiele geeigneter Phosphinoxid-Verbindungen der Formel I für die erfindungsgemässen Aufzeichnungsmassen seien genannt:

2,2-Dimethyl-butyroyldiphenylphosphinoxid,
2,2-Dimethyl-heptanoyl-diphenylphosphinoxid,
2,2-Dimethyl-octanoyl-diphenylphosphinoxid,
2,2-Dimethyl-nonanoyl-diphenylphosphinoxid,
2,2-Dimethyl-octanoyl-phenylphosphonsäuremethylester, 2-Methyl-2-äthyl-hexanoyl-diphenylphosphinoxid, 1-Methyl-1-cyclohexancarbonyl-diphenylphosphinoxid, 2,6-Dimethylbenzoyl-diphenylphosphinoxid, 2,6-Dimethoxybenzoyl-diphenylphosphinoxid, 2,6-Dichlorbenzoyl-diphenylphosphinoxid, 2,6-Dimethoxybenzoyl-phenylphosphonsäuremethylester, 2,4,6-Trimethylbenzoyl-diphenylphosphinoxid, 2,4,6-Trimethylbenzoyl-phenylphosphonsäuremethylester, 2,3,6-Trimethylbenzoyl-diphenylphosphinoxid, 2,3,5,6-Tetramethylbenzoyl-diphenylphosphinoxid, 2,4,6-Trimethoxybenzoyl-diphenylphosphinoxid,
2,4,6-Trichlorbenzoyl-diphenylphosphinoxid,
2-Chlor-6-methylthiobenzoyl-diphenylphosphinoxid, 2,4,6-Trimethylbenzoyl-naphthylphosphinsäuremethylester, 1,3-Dimethoxynaphthalin-2-carbonyl-diphenylphosphinoxid, 2,8-Dimethoxynaphthalin-1-carbonyl-diphenylphosphinoxid,
2,4,6-Trimethylpyridin-3-carbonyl-diphenylphosphinoxid, 2,4-Dimethylchinolin-3-carbonyl-diphenylphosphinoxid, 2,4-Dimethoxyfuran-3-carbonyl-diphenylphosphinoxid und 2,4-Dimethylfuran-3-carbonyl-phenylphosphonsäuremethylester.

Die erfindungsgemässen Aufzeichnungsmassen können die Phosphinoxid-Verbindungen der Formel I als alleinige Photoinitiatoren enthalten, im allgemeinen in einer Menge von 0,005 bis 10 und insbesondere in einer Menge von 0,005 bis 5 Gew.%, bezogen auf die Gesamtmenge der photopolymerisierbaren Aufzeichnungsmasse, doch können die Phosphinoxid-Verbindungen auch in Kombination mit bekannten Photoinitiatoren in den photopolymerisierbaren Aufzeichnungsmassen verwendet werden. Als Beispiele geeigneter bekannter Photoinitiatoren seien die des Ketontyps genannt wie Benzildimethylketal, α-Hydroxyisobutyrophenon oder Diäthoxyacetophenon sowie α-Methylolbenzoinäthyläther, Benzoinmethyläther oder Benzoinisopropyläther.

Es ist oft von Vorteil, in den Aufzeichnungsmassen die Phosphinoxid-Verbindungen der Formel I in Kombination mit tert. Aminen wie Methyldiäthanolamin, Dimethyläthanolamin, Triäthanolamin oder p-Dimethylaminobenzoesäureäthylester zu verwenden. Die Gesamtkonzentration an Initiatorsystem (Photoinitiatoren plus Amine) liegt dabei zwischen 0,05 und 15 Gew.%, bezogen auf die Gesamtmenge der photopolymerisierbaren Aufzeichnungsmasse, wobei der Aminanteil vorzugsweise mindestens gleich der Hälfte des Gesamtinitiatorgehalts ist.

Für die Mischung aus a) und b), die die Basis für die erfindungsgemässen Aufzeichnungsmassen darstellt, sind als niedermolekulare Verbindungen mit mindestens einer photopolymerisierbaren olefinisch ungesättigten Doppelbindung die für solche Massen bekannterweise verwendeten Monomeren geeignet, soweit sie mit den jeweils gewählten polymeren Bindemitteln verträgliche Mischungen bilden und einen Siedepunkt von über 100°C bei Atmosphärendruck haben. Im allgemeinen haben sie ein Molekulargewicht unter 2000 und insbesondere unter 1000. Bevorzugt sind Monomere mit zwei- oder mehr olefinisch ungesättigten photopolymerisierbaren Doppelbindungen allein oder deren Mischungen mit Monomeren mit nur einer olefinisch ungesättigten photopolymerisierbaren Doppelbindung, wobei dann der Anteil der Monomeren mit nur einer Doppelbindung im allgemeinen nur etwa 5 bis 50 und bevorzugt 5 bis 30 Gew.% der Gesamtmonomerenmenge beträgt. Die Art der verwendeten Monomeren richtet sich weitgehend nach der Art des mitverwendeten polymeren Bindemittels. So sind bei Mischungen mit ungesättigten Polyesterharzen besonders zwei- oder mehr Doppelbindungen enthaltende Allylverbindungen, wie Maleinsäuredialkylester, Allylacrylat, Diallylphthalat, Trimellithsäuredi- und -triallylester oder Äthylenglykolbisallylcarbonat, sowie Di- und Polyacrylate und -methacrylate geeignet, wie sie durch Veresterung von Diolen oder Polyolen mit Acrylsäure oder Methacrylsäure hergestellt werden können, wie die Di- und Tri(meth)acrylate von Äthylenglykol, Diäthylenglykol, Triäthylenglykol, Polyäthylenglykol mit einem Molekulargewicht bis etwa 500, 1,2-Propandiol, 1,3-Propandiol, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z.B. Äthylenglykol- oder Di-, Tri- oder Tetraäthylenglykol-monoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organische Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder (Meth)acrylate von Monoalkoholen mit 1 bis 6 C-Atomen. Mischungen von Allylmonomeren mit Di- oder Polyacrylaten sind sehr geeignet. Wählt man Mischungen mit Polyamiden als polymere Bindemittel, so eignen sich von den genannten Monomerarten neben den Di- und Polyacrylaten besonders solche, die zusätzlich zu den Doppelbindungen noch Amid- und/oder Urethangruppen enthalten, wie Derivate von Acrylamiden, z.B. die Umsetzungsprodukte von 2-Mol N-Hydroxymethyl-(meth)acrylamid mit 1 Mol eines aliphatischen Diols, wie Äthylenglykol, Xylylenbisacrylamid oder Alkylenbisacrylamide mit 1 bis 8 C-Atomen im Alkylenrest. Für die Herstellung wässrig-alkalisch entwickelbarer Aufzeichnungsmassen z.B. für die Herstellung von Druckplatten mit Polyvinylalkohol, Polyvinylalkohol-Alkoxylierungsprodukten oder Polyvinylpyrrolidon als polymeren Bindemitteln eignen sich besonders wasserlösliche Monomere, wie z.B. Hydroxyäthyl(meth)-acrylat oder Mono- und Di(meth)acrylate von Polyäthylenglykolen mit einem Molekulargewicht von etwa 200 bis 500. Für die Kombination mit elastomeren Dien-Polymeren als Bindemittel, z.B. mit Polystyrol-Polyisopren-Polystyrol-Dreiblockcopolymeren, Polystyrol-Polybutadien-Zweiblockpolymeren oder Polystyrol-Polyisopren-Zweiblockcopolymeren eignen sich besonders die Polyacrylate oder -methacrylate von Polyolen und insbesondere Glykolen mit mindestens 4 C-Atomen.

Als organische polymere Bindemittel b) für die Mischungen der photopolymerisierbaren Aufzeichnungsmassen und insbesondere für die Herstellung von Druckplatten und Reliefformen kommen die bekannten dafür verwendeten Polymere in Frage, wobei sie mit den mitverwendeten niedermolekularen Verbindungen a) im allgemeinen verträglich und – für den Fachmann selbstverständlich – in einem geeigneten Entwicklerlösungsmittel löslich oder dispergierbar sein sollen, um ein Auswaschen der unbelichteten und unvernetzten Anteile einer Schicht der photopolymerisierbaren Aufzeichnungsmassen nach ihrer bildmässigen Belichtung zu ermöglichen. Als geeignete gesättigte oder ungesättigte Bindemittel seien genannt lineare Polyamide und besonders alkohollösliche Copolyamide, wie sie in der FR-PS 1 520 856 beschrieben sind, Cellulosederivate, insbesondere wässrig-alkalisch auswaschbare Cellulosederivate, Vinylalkohol-Polymere und Polymere und Copolymere von Vinylestern aliphatischer Monocarbonsäuren mit 1 bis 4 C-Atomen, wie Vinylacetat, mit unterschiedlichem Verseifungsgrad, Polyurethane, Polyätherurethane und Polyesterurethane, und ungesättigte Polyesterharze, wie sie z.B. in der DE-OS 20 40 390 beschrieben sind. Von den durch Umsetzung von ungesättigten und gegebenenfalls gesättigten zwei- und gegebenenfalls mehrbasischen Carbonsäuren mit Di- und gegebenenfalls Polyalkoholen hergestellten Polyestern linearer oder verzweigter Natur sind solche mit einer höheren Säurezahl und insbesondere einer Säurezahl zwischen 75 und 160 bevorzugt, da sie in den Massen zu einer guten Dispergierbarkeit oder Löslichkeit in alkalisch-wässrigen Entwicklerlösungsmitteln führen. Bezüglich der Zusammensetzung und Herstellung von ungesättigten Polyesterharzen sei auf die vorhandene Literatur, z.B. das Buch von H.V. Boening, Unsaturated Polyesters, Structure and Properties, Amsterdam 1964, verwiesen.

Die erfindungsgemässen Aufzeichnungsmassen bestehen überwiegend, d.h. zu mehr als 50 und bevorzugt zu 70 bis 100 Gew.% aus der Photoinitiator enthaltenden Mischung aus a) und b). Der Gehalt dieser Mischung an polymerem Bindemittel b) beträgt im allgemeinen etwa 45 bis 90 und insbesondere 45 bis 65 Gew.%, bezogen auf die Summe der Mengen an Polymeren b) und photopolymerisierbaren niedermolekularen Verbindungen a).

Es ist oft zweckmässig, den photopolymerisierbaren Massen in üblichen Mengen auch bekannte Inhibitoren gegen die thermische Polymerisation zuzusetzen, wie Hydrochinon, p-Methoxyphenyl, m-Dinitrobenzol, p-Chinon, Methylenblau, β-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexyl-hydroxylamins.

Die Massen können auch weitere übliche Zusätze enthalten wie Weichmacher, gesättigte niedermolekulare Verbindungen mit Amidgruppen, Wachse usw.

Die Verarbeitung der photopolymerisierbaren Aufzeichnungsmassen, z.B. zu Photopolymerdruckplatten, die schichtförmig die Aufzeichnungsmassen als reliefformende Schicht aufweisen, kann in an sich bekannter Weise erfolgen und ist von der Art der Mischung a) + b) und davon abhängig, ob die Masse flüssig oder fest ist. Die Verarbeitung der Aufzeichnungsmassen (z.B. zu Reliefformen) erfolgt in bekannter Art durch bildmässiges Belichten mit aktinischem Licht mit Lichtquellen, die Maxima der Emission im Bereich der Absorption der Photoinitiatoren, im allgemeinen im Bereich von 300 bis 500 nm besitzen oder einen ausreichenden Anteil von Licht dieses Wellenlängenbereiches aufweisen, wie aktinische oder superaktinische Leuchtstoffröhren, Quecksilber-Nieder-, -Mittel- und -Hochdruckstrahler, die gegebenenfalls auch dotiert sein können, sowie Xenonlampen. Nach der bildmässigen Belichtung werden für die Herstellung von Reliefformen oder Photoresists die nichtbelichteten Anteile der Schicht der Aufzeichnungsmassen in bekannter Art mechanisch entfernt oder mit einem geeigneten Entwicklungslösungsmittel ausgewaschen und die resultierenden Formen, z.B. Reliefdruckformen, getrocknet, in manchen Fällen zweckmässigerweise noch voll nachbelichtet.

Die erfindungsgemässen photopolymerisierbaren Aufzeichnungsmassen zeichnen sich durch eine hohe Reaktivität bei der Belichtung aus, die eine schnellere Aushärtung belichteter Schichtteile ermöglicht. Es ist überraschend, dass die Aufzeichnungsmassen dennoch eine hervorragende Stabilität bei ihrer Lagerung aufweisen. Von besonderem Vorteil ist, dass es mit den neuen Aufzeichnungsmassen oft möglich ist, sogar auf eine Vorbelichtung vor der bildmässigen Belichtung von Schichten dieser photopolymerisierbaren Aufzeichnungsmassen zu verzichten und dennoch mit guten Belichtungszeiten gearbeitet werden kann. Ein unerwarteter grosser Vorteil ist ferner, dass Schichten der erfindungsgemässen Aufzeichnungsmassen, wie in Beispiel 10 gezeigt, bei ihrer Verarbeitung zu Reliefdruckformen verbesserte Reliefstrukturen ergeben, was z.B. beim Druck zu einer deutlich verbesserten Wiedergabe von Negativschriften führt.

Die in den folgenden Synthesebeispielen, Beispielen und Vergleichsversuchen genannten Teile und Prozente beziehen sich, soweit nicht anders angegeben, auf das Gewicht. Teile verhalten sich zu Volumenteilen wie Kilogramm zu Liter.

Synthesebeispiele von Acylphosphinoxidverbindungen der Formel I:

Synthesebeispiel S 1

2,4,6-Trimethylbenzoyl-diphenylphosphinoxid. Zu einer Mischung aus 1350 Volumenteilen Petroläther (Siedebereich 40 bis 70°C), 180 Volumenteilen N,N-Diäthylanilin und 67 Volumenteilen Methanol werden unter Rühren bei 0°C 225 Teile Diphenylchlorphosphin, gelöst in 220 Volumenteilen Petroläther, zugegeben. Danach rührt man die Mischung noch 2 Stunden bei Raumtemperatur. Nach Abkühlung auf ca. +5°C saugt man das ausgeschiedene Aminhydrochlorid ab und destilliert das Filtrat zunächst bei 10 bis 20 Torr, um alles Leichtsiedende zu entfernen. Sodann wird das Diphenylmethoxyphosphin bei 0,1 bis 1 Torr fraktioniert destilliert.

Sdp. $_{0,5}$ 120 bis 124°C. Ausbeute: 175 Teile (80% bezogen auf Diphenylchlorphospin).

In einer Rührapparatur mit Rückflusskühler und Tropftrichter werden bei 50 bis 95°C 648 Teile Methoxydiphenylphosphin zu 547,5 Teilen 2,4,6-Trimethylbenzoylchlorid langsam zugegeben. Man rührt noch 4 bis 5 Stunden bei 50°C nach, löst den Kolbeninhalt bei 30°C in Äther und versetzt bis zur beginnenden Trübung mit Petroläther. Beim Abkühlen kristallisieren 910 Teile (87% d.Th.) 2,4,6-Trimethylbenzoyl-diphenylphosphinoxid. Schwach gelbe Kristalle, Schmelzpunkt 80 bis 81°C.

| | | | |
|---|---|---|---|
| Analyse: | C ber. 75,86 | H ber. 6,03 | P ber. 8,91 |
| | gef. 75,9 | gef. 6,1 | gef. 8,9 |

Synthesebeispiel S 2

2,6-Dimethoxybenzoyl-diphenylphosphinoxid. Wie in Beispiel S 1 beschrieben werden 20 Teile 2,5-Dimethoxybenzoylchlorid in 20 Volumenteilen Toluol suspendiert und zu dieser Mischung bei 50 bis 55°C unter Rühren 21,6 Teile Methoxydiphenylphosphin zugetropft. Man rührt noch 3 Stunden bei 50°C nach und kristallisiert dann direkt aus Toluol um. Man erhält 32 Teile (88% d.Th.) 2,6-Dimethoxybenzoyl-diphenylphosphinoxid. Gelbliche Kristalle, Schmelzpunkt 124 bis 126°C.

Analyse: C ber. 68,85 H ber. 5,19 P ber. 8,47
gef. 68,7 gef. 5,4 gef. 8,2

Synthesebeispiel S 3

2,2-Dimethyloctancarbonyl-diphenylphosphinoxid (Versatoyl-diphenylphosphinoxid). Analog zu Beispiel S 1 tropft man bei 50°C 43,2 Teile Methoxydiphenylphosphin zu 38,3 Teilen 2,2-Dimethyl-heptancarbonsäurechlorid (Versatic-Säurechlorid).

Man rührt 3 Stunden bei 50°C, kühlt auf 15°C ab und rührt die Mischung in eine Aufschlämmung von 60 Teilen Kieselgel in 350 Volumenteilen Toluol ein und rührt noch eine Stunde unter Eiskühlung. Dann wird abgesaugt und das Lösungsmittel unter vermindertem Druck abdestilliert. Versatoyl-diphenylphosphinoxid hinterbleibt als visköses Öl. Ausbeute: 64,5 Teile (90% d. Th.)

Analyse: C ber. 74,16 H ber. 8,15 P ber. 8,71
gef. 74,3 gef. 8,4 gef. 8,5

Beispiel 1

Es wird eine 65%ige methanolische Lösung aus einem Gemisch von 60% eines Copolyamids aus Adipinsäure, Hexamethylendiamin, 4,4'-Diaminodicyclohexylmethan und ε-Caprolactam, 25% des Diäthers aus 1 Mol Äthylenglykol und 2 Molen N-Hydroxymethyl-acrylamid, 13,2% Benzolsulfonamid und 1,8% 2,4,6-Trimethylbenzoyl-diphenylphosphinoxid sowie 0,2% des Aluminiumsalzes des N-Nitrosocyclohexylhydroxylamins und 0,01% eines schwarzen Farbstoffs (Color-Index Nr. 12 195) hergestellt. Die Lösung wird schichtförmig auf ein mit einem Haftlack versehenes Stahlblech so aufgegossen, dass nach dem Trocknen bei etwa 70°C eine Schicht der photopolymerisierbaren Aufzeichnungsmassen mit einer Schichtstärke von 680 µm entsteht. Die resultierende Photopolymerdruckplatte wird, wie im Text angegeben, bildmässig durch eine Vorlage belichtet, und mit einem Alkohol-Wasser-Gemisch werden danach die unbelichteten Schichtanteile ausgewaschen. Die Platte benötigt zur einwandfreien Ausbildung eines 3%igen Rastertonwertes bei einer Rasterlinienweite von 60 Linien pro 1 cm eine Mindestbelichtungszeit von 4 Minuten, wenn die Belichtung mit hochaktinischen Leuchtstoffröhren im Abstand von 5 cm erfolgt.

Beispiel 2

Es wird wie in Beispiel 1 verfahren, jedoch werden nur 11,4% Benzolsuflonamid und zusätzlich 1,8% Methyldiäthanolamin eingesetzt. Die Mindestbelichtungszeit beträgt nur 3 Minuten.

Beispiel 3

Es wird wie in Beispiel 1 verfahren, jedoch wird als Phosphinoxid-Verbindung 1,8% 2,6-Dimethoxybenzoyldiphenylphosphinoxid als Photoinitiator eingesetzt. Die Mindestbelichtungszeit beträgt 4,5 Minuten.

Beispiel 4

Es wird wie in Beispiel 2 verfahren, jedoch werden 1,8% 2,6-Dimethoxybenzoyldiphenylphosphinoxid als Initiator eingesetzt. Die Mindestbelichtungszeit beträgt nur 2,5 Minuten.

Beispiel 5

Es wird wie in Beispiel 2 verfahren, jedoch werden 1,8% Versatoyldiphenylphosphinoxid (2,2-Dimethyloctancarbonyldiphenylphosphinoxid) als Initiator eingesetzt. Die Mindestbelichtungszeit beträgt 3,5 Minuten.

Vergleichsversuch A

Es wird wie in Beispiel 1 verfahren, jedoch werden als Photoinitiator 1,8% Benzildimethylketal eingesetzt. Unter sonst vergleichbaren Bedingungen beträgt hier die Mindestbelichtungszeit 5 Minuten. Die erfindungsgemässen Aufzeichnungsmassen haben somit im Vergleich eine um 25 bis 100% erhöhte Reaktivität.

Beispiel 6

Es wird wie in Beispiel 1 verfahren. Der Zusatz des Farbstoffs unterbleibt jedoch und anstelle des Aluminiumsalzes wird das Kaliumsalz des N-Nitrosocyclohexylhydroxylamins eingesetzt. Die hergestellte Schicht der photopolymerisierbaren Aufzeichnungsmasse hat eine Trockenschichtdicke von 500 µm. Die Platte benötigt zur einwandfreien Ausbildung eines 3%igen Rastertonwertes bei einer Rasterlinienweite von 34 Linien pro cm, die zum Beispiel beim Druck von Zeitungen häufig gewählt wird, eine Mindestbelichtungszeit von 50 Sekunden, wenn die Belichtung mit einer handelsüblichen eisendotierten Quecksilberhochdrucklampe mit Reflektor im Abstand von 50 cm und bei einer elektrischen Leistungsaufnahme des UV-Brenners von 3000 Watt/Stunde erfolgt. Die übrige Verarbeitung der Platte erfolgt wie in Beispiel 1 beschrieben.

Beispiel 7

Es wird wie in Beispiel 6 verfahren, jedoch werden nur 11,4% Benzolsulfonamid eingesetzt. Zusätzlich enthält die Masse 1,8% Methyldiäthanolamin. Die Mindestbelichtungszeit beträgt nur 35 Sekunden.

Beispiel 8

Es wird wie in Beispiel 6 verfahren, jedoch werden nur 11,4% Benzolsulfonamid und zusätzlich 0,9% Methyldiäthanolamin und 0,9% Benzildimethylketal eingesetzt. Ausserdem werden anstelle des 2,4,6-Trimethylbenzoyldiphenylphosphinoxids 1,8% 2,6-Dimethoxybenzoyldiphenylphosphinoxid eingesetzt. Die Mindestbelichtungszeit beträgt hier ebenfalls 35 Sekunden.

Vergleichsversuch B

Es wird wie in Beispiel 6 verfahren, jedoch werden als Photoinitiator 1,8% Benzildimethylketal eingesetzt. Die Mindestbelichtungszeit beträgt unter den angegebenen Bedingungen 55 Sekunden.

Beispiel 9

Zu 650 Teilen eines ungesättigten Polyesters aus Fumarsäure, Trimellithsäureanhydrid und Diäthylenglykol mit einer Säurezahl von 140 werden 400 Teile eines Gemisches gleicher Menge von Tetraäthylenglykoldimethacrylat und Diallylphthalat, 2 Teilen Hydrochinon und 7 Teilen 2,4,6-Trimethylbenzoyldiphenylphosphinoxid zugemischt. Der resultierenden flüssigen Aufzeichnungsmasse werden 110 ppm N-Nitrosodiphenylamin beigegeben.

In an sich bekannter Art werden aus der Aufzeichnungsmasse Reliefdruckformen hergestellt. Hierzu werden die flüssigen Aufzeichnungsmassen schichtförmig auf mit Haftlack versehene Stahlbleche als Träger gegossen, mit einem Rakel Schichtstärken von 800 µm eingestellt und danach die Schichten unter Vermeidung von Lufteinschlüssen mit einer 6 µm starken transparenten Polyesterfolie abgedeckt. Die flüssigen Schichten der Aufzeichnungsmassen werden durch auf die Polyesterfolie aufgelegte Negative mit einer handelsüblichen Quecksilber-Mitteldrucklampe bildmässig belichtet. Negative und Polyesterfolien werden entfernt und danach die unbelichteten Schichtanteile der Aufzeichnungsmassen mit einer 0,5%igen wässrigen Sodalösung ausgewaschen. Die resultierenden Reliefformen werden getrocknet, und jeweils gleichzeitig 2 Minuten nachbelichtet. Als korrekte Belichtungszeit, bei der alle erforderlichen Bildelemente – das sind: Raster mit 40 Linien/cm und einem Tonwert von 3%, freistehende Punkte mit einem Durchmesser der druckenden Fläche von 0,3 mm, feine Linien mit einem Querschnitt von 0,07 mm – einwandfrei auf dem Trägerblech verankert sind, werden unter den gegebenen Bedingungen 9 Belichtungseinheiten, gemessen mit einem handelsüblichen Belichtungsautomaten, ermittelt. Das Relief ist einwandfrei und entspricht den gestellten Forderungen.

Vergleichsversuch C

Es wird genau wie in Beispiel 9 verfahren, jedoch anstelle des 2,4,6-Trimethylbenzoyldiphenylphosphinoxids werden 8 Teile Benzildimethylketal verwendet.

Mit dieser flüssigen Aufzeichnungsmasse wird nach dem zuvor beschriebenen Verfahren eine erforderliche Belichtungszeit von 23 Belichtungseinheiten bestimmt, d.h. eine um den Faktor 2,5 längere Belichtungszeit.

Beispiel 10

294 Teile eines teilweise verseiften Polyvinylacetats (Verseifungsgrad 82 Mol%, Durchschnittspolymerisationsgrad = 500) werden durch mehrstündiges Rühren in 294 Teilen Wasser bei 90°C gelöst. Nach Abkühlen auf 70°C werden unter Rühren 200 Teile eines Monomerengemisches aus 180 Teilen 2-Hydroxyäthylmethacrylat, 20 Teilen 1,1,1-Trimethylolpropantriacrylat, 10 Teilen 2,4,6-Trimethylbenzoyldiphenylphosphinoxid und 2 Teilen 2,6-Di-tert.-butyl-p-kresol zugegeben. Die homogene, viskose Lösung wird filtriert und unter reduziertem Druck entgast. Durch Aufbringen auf ein mit einem Haftlack versehenes Stahlblech und 24stündiges Trocknen bei Raumtemperatur wird eine 550 µm starke nichtklebende Schicht der Aufzeichnungsmasse erhalten. Nach 2 sec. Vorbelichtung und nachfolgender Belichtung von 40 sec. durch ein Negativ in einem mit Leuchtstroffröhren versehenen Flachbelichter und anschliessendem Auswaschen mit Wasser in einem Sprühwascher sowie anschliessendes Trocknen bei 100°C wird ein Klischee mit guter Reliefstruktur und hervorragenden mechanischen Eigenschaften erhalten, von dem mehrere tausend Drucke gedruckt werden konnten. Die Reliefdruckformen geben beim Drucktest gut ausgebildete lesbare Negativschriften, die den Ansprüchen bei Zeitungen voll genügen.

Beispiel 11

Wie in Beispiel 10 wird eine Druckplatte mit der Aufzeichnungsmasse hergestellt, die jedoch anstelle von 2,4,6-Trimethylbenzoyl-diphenylphosphinoxid die gleiche Menge an 2,6-Dimethoxybenzoyl-diphenylphosphinoxid enthält. Die Vorbelichtungszeit beträgt ca. 2 sec., die erforderliche Zeit für die bildmässige Belichtung 45 sec.

Vergleichsversuch D und E

Wie in Beispiel 10 beschrieben wird eine Druckplatte mit einer Aufzeichnungsmasse hergestellt, die jedoch als Photoinitiator in gleicher Menge die bekannten Initiatoren Benzildimethylketal (Vergleichsversuch D) bzw. Benzoinisopropyläther (Vergleichsversuch E) enthält. Der Vergleich der notwendigen Belichtungszeit der Aufzeichnungsmassen bei jeweils gleichem Mengehalt an dem jeweiligen Photoinitiator zeigte folgende Ergebnisse:

| Aufzeichnungsmasse enthaltend | Vorbelichtung | bildmässige Belichtung |
|---|---|---|
| 2,4,6-Trimethylbenzoyldiphenylphosphinoxid (Beispiel 10) | 2 sec. | 40 sec. |
| 2,6-Dimethoxybenzoyldiphenylphosphinoxid (Beispiel 11) | 2 sec. | 45 sec. |
| Benzildimethylketal (Vergleichsversuch D) | 4 sec. | 90 sec. |
| Benzoinisopropyläther (Vergleichsversuch E) | 6 sec. | 120 sec. |

Aus den so belichteten Druckplatten gemäss Vergleichsversuch D hergestellte Reliefdruckformen geben beim Drucktest im Vergleich zu den gemäss Beispiel 10 hergestellten Reliefdruckformen schlechter ausgebildete und unschärfere Negativschriften.

Beispiel 12 und Vergleichsversuch F

Wie in Beispiel 10 und Vergleichsversuch D werden gesondert Druckplatten in gleicher Weise hergestellt, die sich allein dadurch unterscheiden, dass im einen Fall sie 2,4,6-Trimethylbenzoyldiphenylphosphinoxid (Beispiel 12), im anderen Fall Benzildimethylketal (Vergleichsversuch F) in der photopolymerisierbaren Schicht der Aufzeichnungsmasse enthalten. Nebeneinander werden die unterschiedlichen Platten ohne Vorbelichtung direkt mit einer handelsüblichen eisendotierten Quecksilberhochdrucklampe mit Reflektor im Abstand von 75 cm und bei einer elektrischen Leistungsaufnahme des UV-Brenners von 5 kW/Stunde durch ein Negativ bildmässig belichtet und die erforderlichen Mindestbelichtungszeiten bestimmt. Sie betragen bei den Druckplatten gemäss Beispiel 12 (erfindungsgemäss) 60 sec., bei den Druckplatten gemäss Vergleichsversuch F 110 sec.

**Patentansprüche**

1. Photopolymerisierbare Aufzeichnungsmasse, insbesondere für die Herstellung von Druckplatten und Reliefformen überwiegend bestehend aus einer Photoinitiator enthaltenden Mischung von a) mindestens einer niedermolekularen Verbindung mit mindestens einer photopolymerisierbaren olefinisch ungesättigten Doppelbindung und b) mindestens einem organischen polymeren Bindemittel, dadurch gekennzeichnet, dass sie als Photoinitiator Acylphosphinoxid-Verbindungen der Formel:

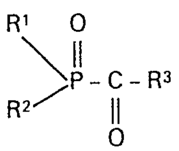

(I)

enthält, wobei

$R^1$ für einen Alkylrest mit 1 bis 6 Kohlenstoffatomen, einen Cycloalkylrest mit 5 oder 6 Ringkohlenstoffatomen, einen gegebenenfalls halogen-, alkyl- oder alkoxy-substituierten Arylrest oder einen S- oder N-haltigen fünf- oder sechsgliedrigen heterocyclischen Rest steht;

$R^2$ die Bedeutung wie $R^1$ hat, wobei $R^1$ und $R^2$ untereinander gleich oder verschieden sein können, oder für einen Alkoxy-, Aryloxy- oder Arylalkoxyrest steht, oder $R^1$ und $R^2$ miteinander zu einem Ring verbunden sind;

$R^3$ einen tertiären Alkylrest mit 4 bis 18 C-Atomen oder tertiären Cycloalkylrest mit 5 oder 6 Ringkohlenstoffatomen darstellt, oder einen Cycloalkylrest, Arylrest, oder 5- oder 6gliedrigen heterocyclischen Rest darstellt, der mindestens in den beiden ortho-Stellungen zur Carbonylgruppierung Substituenten A und B gebunden enthält, wobei A und B Alkyl-, Alkoxy-, Alkoxyalkyl-, Alkylthio-, Cycloalkyl- oder Arylreste oder Halogenatome sind und A und B gleich oder verschieden sein können.

2. Photopolymerisierbare Aufzeichnungsmasse nach Anspruch 1, dadurch gekennzeichnet, dass sie eine Acylphosphinoxid-Verbindung der genannten Formel enthält, worin $R^1$ einen Arylrest mit 6 bis 12 C-Atomen und $R^2$ einen Alkoxyrest mit 1 bis 4 C-Atomen oder einen Arylrest mit 6 bis 12 C-Atomen darstellt.

3. Photopolymerisierbare Aufzeichnungsmasse nach Anspruch 1 oder 2, dadurch gekennzeichnet, dass sie eine Acylphosphinoxid-Verbindung der genannten Formel enthält, worin $R^3$ einen tertiären Alkylrest mit 4 bis 18 C-Atomen oder einen tertiären Cycloalkylrest mit 5 oder 6 Ringkohlenstoffatomen darstellt.

4. Photopolymerisierbare Aufzeichnungsmasse nach Anspruch 1 oder 2, dadurch gekennzeichnet, dass $R^3$ einen mindestens in 2,6-Stellung mit Gruppen A und B substituierten Phenylrest darstellt.

5. Photopolymerisierbare Aufzeichnungsmasse nach einem der Ansprüche 1 bis 4, dadurch gekennzeichnet, dass sie ein tertiäres Amin enthält.

6. Photopolymerisierbare Aufzeichnungsmasse nach einem der Ansprüche 1 bis 5, dadurch gekennzeichnet, dass sie als organisches polymeres Bindemittel ein lineares Polyamid, einen ungesättigten Polyester oder ein Polymeres mit wiederkehrenden Vinylalkoholgruppen in der Molekülhauptkette enthält.

7. Verfahren zur Herstellung von Reliefformen durch bildmässiges Belichten von auf einen Träger aufgebrachten Schichten einer photopolymerisierbaren Aufzeichnungsmasse und nachfolgendes Entfernen der unbelichteten Schichtanteile der photopolymerisierbaren Aufzeichnungsmasse, dadurch gekennzeichnet, dass eine photopolymerisierbare Aufzeichnungsmasse gemäss einem der Ansprüche 1 bis 6 verwendet wird.

**Revendications**

1. Masse d'impression photopolymérisable en particulier pour la fabrication de clichés et formes en relief, constituée essentiellement d'un mélange, contenant un photoinitiateur, de a) au moins un composé, de bas poids moléculaire, présentant au moins une double liaison, à insaturation oléfinique, photopolymérisable et b) au moins un liant polymère organique, caractérisé par le fait qu'elle contient, comme photoinitiateur, des dérivés d'acylphosphinoxyde de formule:

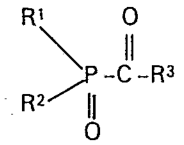 (I)

dans laquelle

$R^1$ représente un reste alkyle ayant 1 à 6 atomes de carbone, un reste cycloalkyle ayant 5 à 6 atomes de carbone de noyau, un reste aryle, éventuellement substitué par halogène, alkyle ou alcoxy, ou un reste hétérocyclique à cinq ou six chaînons et porteur de S ou N;

$R^2$ a la même signification que $R^1$, $R^1$ et $R^2$ pouvant être identiques ou différents, ou représente un reste alcoxy, aryloxy ou arylalcoxy, ou bien $R^1$ et $R^2$ sont reliés ensemble pour former un noyau.

$R^3$ représente un reste alkyle tertiaire ayant 4 à 18 atomes C ou un reste cycloalkyle tertiaire ayant 5 à 6 atomes de carbone de noyau, ou un reste cycloalkyle, un reste aryle ou un reste hétérocyclique à 5 ou 6 chaînons qui contient liés des substituants A et B, au moins dans les deux positions ortho des groupements carbonyle, A et B étant des restes alkyle, alcoxy, alcoxyalkyle, alkylthio, cycloalkyle ou aryle, ou des atomes d'halogène, et A et B pouvant être identiques ou différents.

2. Masse d'impression photopolymérisable selon la revendication 1, caractérisé par le fait qu'elle contient un composé acylphosphinoxyde de la formule indiquée, où $R^1$ représente un reste aryle ayant 6 à 12 atomes C et $R^2$ un reste alcoxy ayant 1 à 4 atomes C ou un reste aryle ayant 6 à 12 atomes C.

3. Masse d'impression photopolymérisable selon la revendication 1 ou 2, caractérisé par le fait qu'elle contient un composé acylphosphinoxyde de la formule indiquée, où $R^3$ représente un reste alkyle tertiaire ayant 4 à 18 atomes C ou un reste cycloalkyle tertiaire ayant 5 à 6 atomes de carbone de noyau.

4. Masse d'impression photopolymérisable selon la revendication 1 ou 2, caractérisé par le fait que $R^3$ représente un reste phényle substitué par des groupes A et B au moins en position 2,6.

5. Masse d'impression photopolymérisable selon l'une des revendications 1 à 4, caractérisé par le fait qu'elle contient une amine tertiaire.

6. Masse d'impression photopolymérisable selon l'une des revendications 1 à 5, caractérisé par le fait qu'elle contient, comme liant polymère organique, un polyamide linéaire, un polyester insaturé ou un polymère à groupes vinylalcool répétitifs dans la chaîne principale de la molécule.

7. Procédé de fabrication de formes en relief par exposition, selon l'image, d'une couche de masse d'impression polymérisable appliquée sur un support, puis élimination des parties de la couche de masse d'impression polymérisable non exposée, caractérisé par le fait qu'on utilise une masse d'impression photopolymérisable selon l'une des revendications 1 à 6.

## Claims

1. A photopolymerizable recording composition, in particular for the preparation of printing plates and relief plates, which consists mainly of a mixture, containing a photoinitiator, of a) one or more low molecular weight compounds possessing one or more photopolymerizable olefinically unsaturated double bonds and b) one or more organic polymeric binders, wherein the photoinitiator used is an acylphosphine oxide compound of the formula

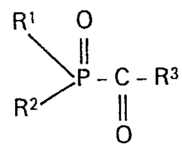 (I)

where

$R^1$ is alkyl of 1 to 6 carbon atoms, cycloalkyl of 5 or 6 ring carbon atoms, aryl which is unsubstituted or substituted by halogen, alkyl or alkoxy, or an S-containing or N-containing five-membered or six-membered heterocyclic radical,

$R^2$ has one of the meanings of $R^1$, but $R^1$ and $R^2$ may be identical or different, or is alkoxy, aryloxy or aralkoxy, or $R^1$ and $R^2$ together form a ring, and

$R^3$ is tertiary alkyl of 4 to 18 carbon atoms or tertiary cycloalkyl of 5 or 6 ring carbon atoms or is a cycloalkyl, aryl or 5-membered or 6-membered heterocyclic radical which contains substituents A and B at least in the two positions ortho to the carbonyl group, A and B being identical or different and each being alkyl, alkoxy, alkoxyalkyl, alkylthio, cycloalkyl, aryl or halogen.

2. A photopolymerizable recording composition as claimed in claim 1, which contains an acylphosphine oxide compound of the said formula, where $R^1$ is aryl of 6 to 12 carbon atoms, and $R^2$ is alkoxy of 1 to 4 carbon atoms or aryl of 6 to 12 carbon atoms.

3. A photopolymerizable recording composition as claimed in claim 1 or 2, which contains an acylphosphine oxide compound of the said formula, where $R^3$ is tertiary alkyl of 4 to 18 carbon atoms or tertiary cycloalkyl of 5 or 6 ring carbon atoms.

4. A photopolymerizable recording composition as claimed in claim 1 or 2, where $R^3$ is phenyl substituted by groups A and B at least in the 2- and 6-positions.

5. A photopolymerizable recording composition as claimed in any of claims 1 to 4, which contains a tertiary amine.

6. A photopolymerizable recording composition as claimed in any of claims 1 to 5, wherein the organic polymeric binder used is a linear polyamide, an unsaturated polyester or a polymer with recurring vinyl alcohol groups in the main chain of the molecule.

7. A process for the preparation of a relief plate by imagewise exposure of a layer, applied to a support, of a photopolymerizable recording composition, and subsequent removal of unexposed areas of the layer of photopolymerizable recording composition, wherein a photopolymerizable recording composition as claimed in any of claims 1 to 6 is used.